# EUROPÄISCHE PATENTSCHRIFT

(11) **EP 1 472 588 B1**
(45) Veröffentlichungstag und Bekanntmachung des Hinweises auf die Patenterteilung: **07.09.2005**
(21) Anmeldenummer: 03704488.0
(22) Anmeldetag: 29.01.2003
(51) Int. Cl.: G06F 1/00

(54) **VORRICHTUNG UND VERFAHREN ZUM UNBRAUCHBARMACHEN ELEKTRONISCHER GER TE**
DEVICE AND METHOD FOR DISABLING ELECTRONIC DEVICES
DISPOSITIF ET PROCEDE POUR RENDRE DES APPAREILS ELECTRONIQUES INUTILISABLES

(30) Priorität: 06.02.2002 DE 10204685
(43) Veröffentlichungstag der Anmeldung: 03.11.2004
(73) Patentinhaber: Fraunhofer-Gesellschaft zur Förderung der angewandten Forschung e.V., 80636 München (DE)
(72) Erfinder: ECKL, Wilhelm, 76228 Karlsruhe (DE); EISENREICH, Norbert, 76327 Pfinztal (DE); WELLER, Franz, 73432 Aalen-Waldhausen (DE); EBELING, Hans, 76135 Karlsruhe (DE); NEUTZ, Jochen, 76227 Karlsruhe (DE)
(86) Internationale Anmeldenummer: PCT/EP2003/000876
(87) Internationale Veröffentlichungsnummer: WO 2003/066248

(56) Entgegenhaltungen:
- WO-A-97/24765
- FR-A- 2 578 209
- FR-A- 2 805 116
- US-A- 3 725 671
- US-A- 6 011 473

## Beschreibung

Die Erfindung betrifft eine Vorrichtung zum Unbrauchbarmachen elektronischer Geräte und ein entsprechendes Verfahren.

Eine Vielzahl von Daten wird gegenwärtig auf elektronischen Speichermedien, wie Festplatten von Computern oder Laptops, Mikrochips von mobilen Datenbanken, Terminplanern, Mobiltelefonen oder dergleichen gespeichert, wobei es in der Regel eine unbefugte Kenntnisnahme der Daten seitens Dritter zu verhindern gilt. Dies betrifft insbesondere solche Informätionen, die dem Datenschutz unterliegen oder anderweitig, z.B. aus sicherheitstechnischen oder militärischen Gründen, eine Geheimhaltung erfordern. Ferner sei das grundsätzliche Interesse von Unternehmen an der Geheimhaltung betriebsinterner Informationen, z.B. Forschungsergebnissen, Kundendateien etc., erwähnt.

Insbesondere im Zuge der fortschreitenden Erhöhung der Speicherkapazität von elektronischen Datenträger besteht ein zwingender Bedarf, einen unbefugten Zugriff auf die gespeicherten Daten zu verhindern. Dieser Bedarf besteht bei portablen Geräten, wie Laptops, Terminplanern oder Mobiltelefonen, um so mehr, als sie häufig gestohlen werden und die softwaretechnische Sicherung vor einem Zugriff auf die gespeicherten Daten, wie Pässwörter oder dergleichen, häufig keinen wirksamen Schutz gewährleistet. Darüber hinaus besteht ein Interesse in gewissen Fällen derartige elektronische Geräte unbrauchbar zu machen. Die Verwendung von Sprengstoffen zur Zerstörung elektronischer Geräte ist bekannt aus US-A-6011473, FR-A-2805116 und US-A-3725671.

Der Erfindung liegt die Aufgabe zugrunde, elektronische Geräte sicher und zuverlässig unbrauchbar zu machen.

Zur Lösung der erfindungsgemäßen Aufgabe sieht ein gattungsgemäßes Verfahren einen Gasgenerator mit einem pyrotechnischen Treibsatz vor, wobei wenigstens ein Brennstoff oder wenigstens ein Oxidator des Treibsatzes beim Auslösen desselben gut leitfähige Metalle, insbesondere Edel- oder Halbedelmetalle, freisetzen, welche sich auf elektronischen Teilen des elektronischen Geräts abscheiden.

Die erfindungsgemäße Ausgestaltung sorgt beim Zünden des Gasgenerators dafür, dass Metalle, insbesondere metallhaltige Aerosole sich auf Platinen zwischen Leiterbahnen absetzen und dort zu leitfähigen Bindern führen, die einen Kurzschluss zwischen den Leiterbahnen bewirken und damit zur Funktionsuntüchtigkeit des Geräts führen. Enthält das elektrische Gerät Speichermedien, so sorgt die Erfindung auch für eine irreversible Schädigung desselben, so daß die hierauf gespeicherten Daten dauerhaft vernichtet werden und ein unbefugter Zugriff auf die Daten sicher vermieden wird.

Zur Vermeidung einer gesundheitlichen Beeinträchtigung sowie eines unzeitigen Auslösens des Gasgenerators sind einerseits thermisch-mechanische Unempfindlichkeit des Treibsatzes, andererseits toxikologische Unbedenklichkeit sowohl des Treibsatzes als auch der von diesem freigesetzten, zumeist gasförmigen Produkte erwünscht. Ein solcher Gasgenerator arbeitet in einem breiten Temperaturintervall sicher und zuverlässig unter Vermeidung eines unerwünschten Auslösens infolge mechanischer oder thermischer Einwirkung. Die geringe Baugröße moderner Gasgeneratoren erlaubt einen Einbau selbst in miniaturisierte moderne Kommunikationsmittel, wie Mobiltelefone, Organizer, Laptops oder dergleichen.

Erfindungsgemäß erfolgt eine Unbrauchbarmachung des Geräts primär durch Erzeugung von Kurzschlußbindern derart, dass der durch wenigstens ein Brennstoff oder wenigstens ein Oxidator des Treibsatzes beim Auslösen metallhaltige Flüssig- oder Feststoff-Aerosole freisetzt, welche sich in elektronischen Gerät abscheiden. Die von dem Treibsatz beim Zünden freigesetzten Aerosole, die z.B. heiße Partikel, Tröpfchen der Dämpfe aus Metallen, Metalloxiden oder dergleichen enthalten können, scheiden sich auf den kalten Oberfläche der Platinen oder des Speichermediums ab und bewirken eine irreparable Schädigung der Werkstoffstruktur, welche die optischen, dielektrischen und/oder magnetischen Eigenschaften verändert, beispielsweise durch einen Kurzschluss zwischen den Leiterbahnen, wobei eventuell vorhandenen Lack- oder Schutzschichten aufgrund der hohen thermischen Energie durchdrungen werden, oder durch Eindringen von beim Abbrand entstandenen Aerosolen, in z.B. Festplatten oder Datenträgerlaufwerke. Durch den metallischen Niederschlag wird das Gerät oder das Speichermedium dauerhaft außer Funktion gesetzt, d.h. im letztgenannten Fall werden gespeicherte Daten unwiederbringlich gelöscht. Auch kann eine Vernichtung von Daten aufgrund einer irreversiblen thermischen Schädigung des Speichermediums infolge Abbrand des pyrotechnischen Treibsatzes geschehen. Durch geeignete Platzierung des Gasgenerators können somit elektronische Bauteile und damit Geräte vollständig unbrauchbar gemacht werden.

In bevorzugter Ausführung ist vorgesehen, daß der Oxidator aus der Gruppe der Metallnitrate, Metallaminnitrate oder Mischungen hieraus gewählt ist, wobei der Oxidator insbesondere aus der Gruppe Kupferdiamindinitrat [Cu(NH₃)₂] (NO₃)₂, Kupfertetramindinitrat [Cu(NH₃)₄] (NO₃)₂, basisches Kupferniträt Cu(NO₃)₂ · 3 Cu (OH)₂ oder Mischungen hieraus gewählt sein kann. Ein solcher Oxidator ist an sich aus der DE 44 42 037 Cl bekannt. Er ist ungiftig, liefert ungiftige Zersetzungsprodukte und weist bei hoher Abbrandgeschwindigkeit auch unter extremen Einsatzbedingungen eine lange Lebensdauer und Funktionstüchtigkeit auf. Er zeichnet sich ferner durch eine geringe Hygroskopizität aus, so daß er auch unter feuchten Umgebungsbedingungen einwandfrei wirksam ist. Beim Abbrand eines solchen Oxidators entsteht ein starker metallhaltiger Aerosolaustrag, welcher in einer Abscheidung von elementarem Kupfer auf dem Speichermedium resultiert, so daß letzteres dauerhaft beschädigt wird.

Sofern allein der eingesetzte Oxidator den gewünschten metallhaltigen Aerosolaustrag bewirkt, kommen als Brennstoffe im Prinzip beliebige bekannte organische oder anorganische Vertreter in Betracht, wobei der Brennstoff z.B. aus der Gruppe 3-Nitro-1,2,4-triazol-5-on (NTO), Nitroguanidin (NIGU), Triaminoguanidinnitrat (TAGN), 5-Amino-1H-tetrazol (5-ATZ), Diguanidinium-5,5'-azotetrazolat (GZT) oder Mischungen hiervon gewählt sein kann. Die genannten Brennstoffe sind einerseits unempfindlich und toxikologisch unbedenklich, andererseits weisen sie einen verhältnismäßig hohen molekularen Stickstoffanteil bei einem relativ niedrigen Kohlenstoffanteil auf, so daß sie vornehmlich zu ungiftigem Stickstoff (N₂) umgesetzt werden. Der Kohlenstoffanteil wird von dem Oxidator im wesentlichen vollständig zu ungiftigem Kohlendioxid oxidiert.

Sofern anstelle des Oxidators oder zusätzlich zu diesem der Brennstoff beim Abbrand des Treibsatzes für den gewünschten metallhaltigen Aerosolaustrag sorgen soll, ist in bevorzugter Ausführung vorgesehen, daß der Brennstoff aus der Gruppe der eine hohe Sauerstoffreaktionsfähigkeit aufweisenden Metalle, Halbmetalle, Legierungen derselben oder Mischungen hieraus in feinpartikulärer Form gewählt ist (DE 44 42 027 Cl). In diesem Fall bieten sich insbesondere Metalle aus der Gruppe Aluminium (Al), Silicium (Si), Magnesium (Mg), Titan (Ti), Wolfram (W), Zirconium (Zr), Kupfer (Cu), Bor (B) oder Mischungen hieraus in feinpartikulärer Form an, welche sich als metallische oder feste metalloxidische Schicht auf dem Speichermedium abscheiden.

Eine andere bevorzugte Ausführung sieht vor, daß der Brennstoff aus der Gruppe der metallorganischen Verbindungen gewählt ist, wobei beispielsweise Metallalkyl-, Metallalkenyl-, Metallalkinyl-, Metallaryl-, Metallcarbonylverbindungen etc. in Betracht kommen, welche insbesondere die vorgenannten Metalle enthalten, z.B. Trimethylaluminium (Al(CH₃)₃). Ferner haben sich Metallwasserstoffverbindungen, wie TiH₂, SiH₄, etc. als geeignet erwiesen.

Der Zünder des Gasgenerators kann zunächst manuell auslösbar sein, wobei z.B. vorgesehen sein kann, daß der Zünder im Falle einer wiederholten Falscheingabe eines Passworts aktiviert wird, so daß der Versuch eines unbefugten Zugriffs auf die auf dem Speichermedium gespeicherten Daten zur Zerstörung derselben führt. Auch kann vorgesehen sein, daß der Zünder sensorisch auslösbar ist, wobei grundsätzlich beliebige bekannte Sensoren, wie Lichtschranken, Bewegungsmelder, Wärme- oder Schallsensoren, Drucksensoren oder dergleichen, in Frage kommen. Ein sensorisch auslösbarer Zünder bietet sich z.B. zum Datenschutz von stationär in Gebäuden oder Verkehrsmitteln, z.B: Zivil- oder Militärflugzeugen mit elektronischen Waffensystemen, untergebrachten Speichermedien von Computern öder Mikrochips an. Schließlich kann der Zünder auch fernsteuerbar, insbesondere mittels eines telefonisch oder elektronisch, z.B. per E-mail oder Short-Message-Service (SMS), fernübermittelbaren Codes auslösbar sein, was insbesondere bei portablen Geräten, wie Laptops, Mobiltelefonen oder Terminplanern, einen wirksamen Schutz vor unbefugter Kenntnisnahme der gespeicherten Daten im Falle eines Abhandenkommens der Geräte gewährleistet.

Die vorgenannten Zündverfahren können auch konkretisiert sein, wobei der Zünder zweckmäßig elektrisch aktivierbar ist und er vorzugsweise von einer Stromversorgungseinrichtung des Speichermediums mit Strom versorgt ist. Während im Falle eines in stationären Datenverarbeitungsanlagen untergebrachten Speichermediums eine Versorgung des Zünders mit Netzspannung vorteilhaft ist, ist im Falle von in portablen Geräten untergebrachten Speichermedien ein durch Batterien oder Akkumulatoren mit Strom versorgter Zünder zweckmäßig.

Ein einfacher und kostengünstiger Aufbau der erfindungsgemäßen Vorrichtung ist beispielsweise durch einen mit dem Treibsatz in Verbindung stehenden Zünddraht möglich, welcher den Zündvorgang des Treibsatzes elektrisch bzw. thermisch initiiert.

Der Gasgenerator und das Speichermedium sind bevorzugt in einem Schutzgehäuse angeordnet, um einen Austritt der Zersetzungsprodukte des Treibsatzes, insbesondere des metallhaltigen Aerosols, beim Abbrand des Treibsatzes in die Umgebung zu verhindern.

Die Erfindung betrifft ferner eine elektronische Datenverarbeitungsanlage, insbesondere Computer, Laptops, Terminplaner oder dergleichen, ein Telefon, insbesondere Mobiltelefon oder auch ein Speichergerät, wie eine Festplatte, ein optischer Brenner, oder ein Lesegerät mit einem Speichermedium, wie ein CD-ROM oder DVD-Laufwerk, welche mit einer Vorrichtung der vorgenannten Art ausgestattet sind.

Nachfolgend ist die Erfindung anhand eines ein Speichermedium beinhaltenden Ausführungsbeispiels unter Bezugnahme auf die Zeichnung näher erläutert. In der Zeichnung zeigen:
- Fig. 1: eine perspektivische Ansicht eines Gasgenerators;
- Fig. 2: eine Seitenansicht des Gasgenerators gemäß Fig. 1 und
- Fig. 3: einen Querschnitt III-III durch den Gasgenerator gemäß Fig. 1 und 2.
- Fig. 4: die Anordnung einer erfindungsgemäßen Vorrichtung zusammen mit elektronischen Bauteilen auf einer Leitplatte.

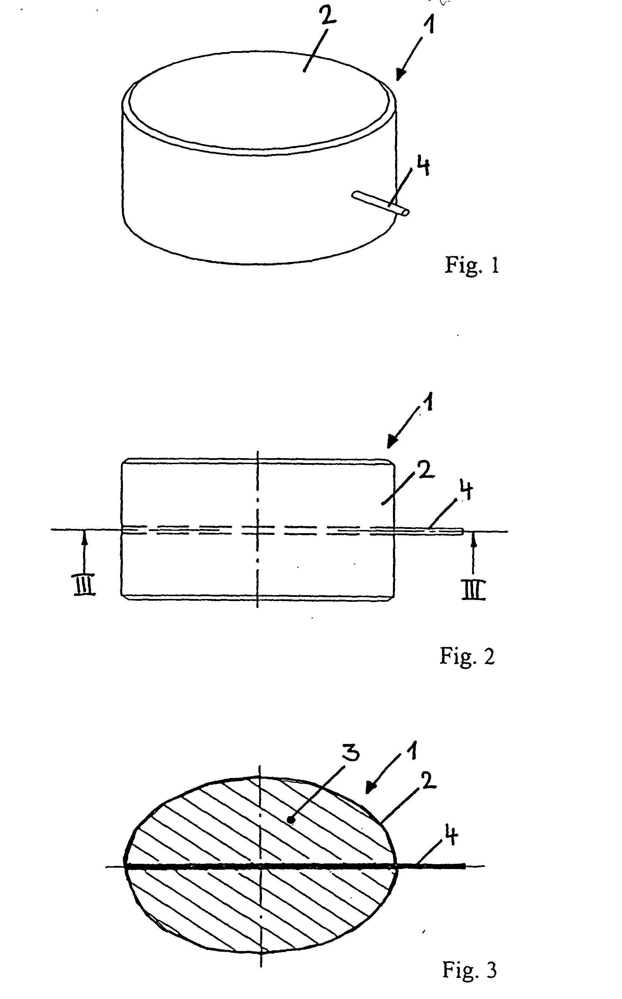

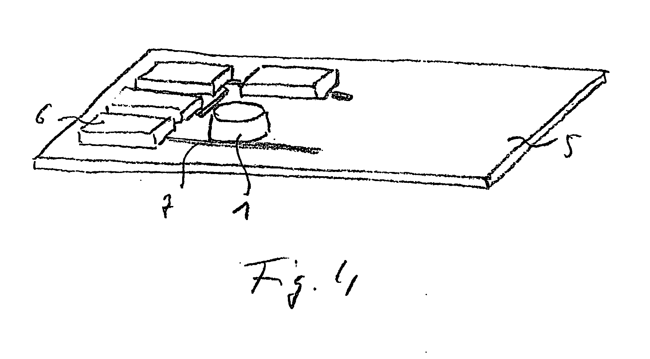

Fig. 1 zeigt einen Gasgenerator 1, der zur Vernichtung von auf einem Speichermedium (nicht dargestellt) elektronisch gespeicherter Daten dient und in unmittelbarer Nähe des Speichermediums, z.B. auf einer Platine (Fig. 4) des Speichermediums in Form eines Mikrochips, angeordnet ist. Der Gasgenerator 1 weist ein Gehäuse 2 und einen im Gehäuse 2 untergebrachten Treibsatz 3 (Fig. 3) auf. Das Gehäuse 2 ist beim vorliegenden Ausführungsbeispiel von einem dünnwandigen Kunststoffzylinder gebildet, der beim Zünden des Treibsatzes 3 zerbirst. Der Treibsatz 3 besteht z.B. aus einer homogenen Mischung aus feinpartikulärem Aluminiumpulver (Brennstoff) sowie [Cu (NH₃)₄] (NO₃)₂ und Cu(NO₃)₂ · 3 Cu (OH)₂ (Oxidator) im Verhältnis von etwa 5:70:25 Mass.-%. Ein nicht näher dargestellter Zünder weist einen in den Treibsatz 3 inkorporierten Zünddraht 4 auf, welcher beim vorliegenden Ausführungsbeispiel das zylindrische Gehäuse 2 radial durchsetzt. Der Zünder ist von einer Stromversorgungseinrichtung des Speichermediums mit Strom versorgt und beispielsweise mittels eines fernübermittelbaren Codes auslösbar. Der Gasgenerator 1 und das Speichermedium können in einem gemeinsamen Schutzgehäuse (nicht dargestellt) untergebracht sein. Der Gasgenerator 1 ist in Fig. 2 nochmals in Seitenansicht gezeigt.

Die Fig. 4 zeigt eine Leiterplatte 5, auf der elektronische Bauelemente 6 sowie beispielhaft einige Leiterbahnen 7 und schließlich eine erfindungsgemäße Vorrichtung in Form eines Gasgenerators 1 angeordnet sind.

Beim Zünden des Gasgenerators 1 entsteht eine Druckwelle, so daß das Gehäuse 2 zerbirst und infolge Abbrand des Treibsatzes 3 metallhaltige Aerosole gebildet werden, die sich als nicht mehr entfernbare Metall- bzw. Metalloxidschicht auf dem Speichermedium niederschlagen. Ferner findet eine thermische Schädigung des Speichermediums aufgrund der freiwerdenden Reaktionsenthalpie statt. Das Speichermedium erfährt auf diese Weise eine irreparable Schädigung, so daß die hierauf gespeicherten Daten dauerhaft und unwiederbringlich vernichtet werden.

## Patentansprüche

1. Vorrichtung zum Unbrauchbarmachen elektronischer Geräte, **gekennzeichnet durch** einen Gasgenerator (1) mit einem pyrotechnischen Treibsatz, wobei wenigstens ein Brennstoff oder wenigstens ein Oxidator des Treibsatzes beim Auslösen desselben gut leitfähige Metalle, insbesondere Edel- oder Halbedelmetalle freisetzte, welche sich auf elektronischen Teilen des elektronischen Geräts abscheiden.

2. Vorrichtung nach Anspruch 1, **dadurch gekennzeichnet, dass** Brennstoff und/oder Oxidator die Metalle dampfförmig oder als Aerosole (Flüssig- oder Feststoffaerosole) freisetzten.

3. Vorrichtung nach Anspruch 1 oder 2, **dadurch gekennzeichnet, dass** ein Treibsatz (3) im Bereich der Platine und/oder eines Speichermediums des elektrischen Geräts angeordnet ist.

4. Vorrichtung nach einem der Ansprüche 1 bis 3, **dadurch gekennzeichnet, daß** der Oxidator aus der Gruppe der Edel- oder Halbedel-Metallnitrate, Metallaminnitrate, Mischungen hieraus aufweist.

5. Vorrichtung nach Anspruch 4, **dadurch gekennzeichnet, daß** der Oxidator aus Kupfer-Verbindungen von Edel- oder Halbedelmetallen der Gruppe Kupferdiamindinitrat [Cu (NH₃)₂] (NO₃)₂, Kupfertetramindinitrat [Cu (NH₃)₄] (NO₃)₂, basisches Kupfernitrat Cu(NO₃)₂ · 3 Cu(OH)₂ oder Mischungen hieraus aufweist.

6. Vorrichtung nach einem der Ansprüche 1 bis 5, **dadurch gekennzeichnet, daß** der Brennstoff aus der Gruppe der eine hohe Sauerstoffreaktionsfähigkeit aufweisenden Edel- oder Halbmetalle, Legierungen derselben bzw. diese entladenden Legierung oder Mischungen hieraus in feinpartikulärer Form aufweist.

7. Vorrichtung nach Anspruch 6, **dadurch gekennzeichnet, daß** der Brennstoff aus der Gruppe Aluminium (Al), Silicium (Si), Magnesium (Mg), Titan (Ti), Wolfram (W), Zirconium (Zr), Kupfer (Cu), Bor (B) oder Mischungen hieraus in feinpartikulärer Form gewählt ist.

8. Vorrichtung nach einem der Ansprüche 1 bis 7, **dadurch gekennzeichnet, daß** der Brennstoff aus der Gruppe der metallorganischen Verbindungen gewählt ist.

9. Vorrichtung nach einem der Ansprüche 1 bis 8, **dadurch gekennzeichnet, daß** der Brennstoff aus der Gruppe der Metallwasserstoffverbindungen gewählt ist.

10. Vorrichtung nach einem der vorangehenden Ansprüche, **dadurch gekennzeichnet, dass** der Gasgenerator (1) einen dem Treibsatz (3) wirkverbundenen Zünder aufweist.

11. Vorrichtung nach Anspruch 10, **dadurch gekennzeichnet, daß** der Zünder manuell auslösbar ist.

12. Vorrichtung nach Anspruch 10 oder 11, **dadurch gekennzeichnet, daß** der Zünder sensorisch auslösbar ist'.

13. Vorrichtung nach einem der Ansprüche 11 bis 12, **dadurch gekennzeichnet, daß** der Zünder fernsteuerbar auslösbar ist.

14. Speichergerät mit einer Vorrichtung nach einem der Ansprüche 1 bis 11.

15. Lesegerät mit einem Speichermedium, wobei das Lesegerät eine Vorrichtung nach einem der Ansprüche 1 bis 11 aufweist.

16. Verfahren zum Unbrauchbarmachen elektronischer Geräte, **dadurch gekennzeichnet, dass** ein in einem solchen Gerät vorgesehener Gasgenerator mit einem pyrotechnischen Treibsatz gezündet wird, der wenigstens einen Brennstoff oder wenigstens einen Oxidator enthält, von denen zumindest einer beim Auslösen des Treibsatzes gut leitfähige Metalle, insbesondere Edel- oder Halbedelmetalle freisetzt, welche sich auf elektronischen Teilen des elektronischen Geräts abscheiden.

17. Verfahren nach Anspruch 16, **dadurch gekennzeichnet, dass** der Brennstoff oder der Oxidator Metalle als Dämpfe oder Aerosole (Flüssig- oder Feststoffaerosole) freisetzt.

18. Verfahren nach Anspruch 16 oder 17, **gekennzeichnet durch** einen im Bereich einer Platine und/oder eines Speichermediums des elektrischen Geräts angeordneten Treibsatz.

19. Verfahren nach einem der Ansprüche 16 bis 18, **dadurch gekennzeichnet, dass** ein Oxidator aus, der Gruppe der Edel- oder Halbedel-Metallnitrate, Mischungen hieraus verwendet wird.

20. Verfahren nach Anspruch 19, **dadurch gekennzeichnet, dass** ein Oxidator aus Kupfer-Verbindungen von Edel- oder Halbedelmetallen der Gruppe Kupferdiamindinitrat [Cu(NH₃)₂](NO₃)₂, Kupfertetramindinitrat [Cu (NH₃)₄](NO₃)₂, basisches Kupfernitrat Cu(NO₃)₂ · 3 Cu(OH)₂ oder Mischungen hieraus verwendet wird.

21. Verfahren nach einem der Ansprüche 16 bis 20, **dadurch gekennzeichnet, dass** ein Brennstoff aus der Gruppe der eine hohe Sauerstoffreaktionsfähigkeit aufweisenden Edel- oder Halbmetalle, Legierungen derselben bzw. diese entladenden Legierung oder Mischungen hieraus in feinpartikulärer Form verwendet wird.

22. Verfahren nach Anspruch 21, **dadurch gekennzeichnet, dass** ein Brennstoff aus der Gruppe Aluminium (Al), Silicium (Si), Magnesium (Mg), Titan (Ti), Wolfram (W), Zirconium (Zr), Kupfer (Cu), Bor (B) oder Mischungen hieraus in feinpartikulärer Form verwendet wird.

23. Verfahren nach einem der Ansprüche 16 bis 21, **dadurch gekennzeichnet, dass** ein Brennstoff aus der Gruppe der metallorganischen Verbindungen verwendet wird.

24. Verfahren nach einem der Ansprüche 16 bis 23, **dadurch gekennzeichnet, dass** ein Brennstoff aus der Gruppe der Metallwasserstoffverbindungen verwendet wird.

25. Verfahren nach einem der Ansprüche 16 bis 24, **dadurch gekennzeichnet, dass** der Treibsatz mittels eines mit ihm wirkverbundenen Zünders des Gasgenerators gezündet wird.

## Claims

1. Device for disabling electronic devices, **characterised by** a gas generator (1) with a pyrotechnical propellant charge, wherein at least one fuel or at least one oxidant of the propellant charge releases, after activation thereof, favourably conductive metals, in particular precious or semiprecious metals, which are deposited onto electronic parts of the electronic device.

2. Device according to Claim 1, **characterised in that** fuel and/or oxidant releases the metals in vapour form or as aerosols (liquid or solid aerosols).

3. Device according to Claim 1 or 2, **characterised in that** a propellant charge (3) is arranged in the region of the board and/or a storage medium of the electrical device.

4. Device according to one of Claims 1 to 3, **characterised in that** the oxidant is from the group of precious or semiprecious metal nitrates, metal amine nitrates, mixtures thereof.

5. Device according to Claim 4, **characterised in that** the oxidant is selected from copper compounds of precious or semiprecious metals of the group copper diamine dinitrate [Cu(NH₃)₂] (NO₃)₂, copper tetramine dinitrate [Cu(NH₃)₄] (NO₃)₂, basic copper nitrate (Cu(NO₃)₂ · 3 Cu(OH)₂ or mixtures thereof.

6. Device according to one of Claims 1 to 5, **characterised in that** the fuel is selected from the group of precious or semiprecious metals with high oxygen reactivity, alloys thereof or alloys discharging these or mixtures thereof in fine particulate form.

7. Device according to Claim 6, **characterised in that** the fuel is selected from the group: aluminium (Al), silicon (Si), magnesium (Mg), titanium (Ti), tungsten (W), zirconium (Zr), copper (Cu), boron (B) or mixtures thereof in fine particulate form.

8. Device according to one of Claims 1 to 7, **characterised in that** the fuel is selected from the group of organo-metallic compounds.

9. Device according to one of Claims 1 to 8, **characterised in that** the fuel is selected from the group of metal-hydrogen compounds.

10. Device according to one of the preceding claims, **characterised in that** the gas generator (1) has an igniter actively connected to the propellant charge (3).

11. Device according to Claim 10, **characterised in that** the igniter can be activated manually.

12. Device according to Claim 10 or 11, **characterised in that** the igniter can be activated by sensor.

13. Device according to one of Claims 11 to 12, **characterised in that** the igniter can be activated by remote control.

14. Storage device with a device according to one of Claims 1 to 11.

15. Reading device with a storage medium, wherein the reading device has a device according to one of Claims 1 to 11.

16. Method for disabling electronic devices, **characterised in that** a gas generator provided in such a device is ignited with a pyrotechnic propellant charge, which contains at least one fuel or at least one oxidant, of which at least one releases favourably conductive metals during activation of the propellant, in particular precious or semiprecious metals, which are deposited on electronic parts of the electronic device.

17. Method according to Claim 16, **characterised in that** the fuel or the oxidant releases the metals as vapours or aerosols (liquid or solid aerosols).

18. Method according to Claim 16 or 17, **characterised by** a propellant charge arranged in the region of a board and/or a storage medium of the electrical device.

19. Method according to one of Claims 16 to 18, **characterised in that** an oxidant from the group of precious or semiprecious metal nitrates, metal amine nitrates, mixtures thereof is used.

20. Method according to Claim 19, **characterised in that** an oxidant comprising copper compounds of precious or semiprecious metals of the group copper diamine dinitrate [Cu(NH₃)₂] (NO₃)₂, copper tetramine dinitrate [Cu(NH₃)₄] (NO₃)₂, basic copper nitrate (Cu(NO₃)₂ · 3 Cu(OH)₂ or mixtures thereof is used.

21. Method according to one of Claims 16 to 20, **characterised in that** a fuel from the group of precious or semiprecious metals with high oxygen reactivity, alloys thereof or alloys discharging these or mixtures thereof in fine particulate form is used.

22. Method according to Claim 21, **characterised in that** a fuel from the group: aluminium (Al), silicon (Si), magnesium (Mg), titanium (Ti), tungsten (W), zirconium (Zr), copper (Cu), boron (B) or mixtures thereof in fine particulate form is used.

23. Method according to one of Claims 16 to 21, **characterised in that** a fuel from the group of organo-metallic compounds is used.

24. Method according to one of Claims 16 to 23, **characterised in that** a fuel from the group of metal-hydrogen compounds is used.

25. Method according to one of Claims 16 to 24, **characterised in that** the propellant charge is ignited by means of an igniter actively connected to it.

## Revendications

1. Dispositif pour rendre inutilisables des appareils électroniques,
**caractérisé par**
un générateur de gaz (1) contenant une charge pyrotechnique, dans lequel au moins un combustible ou au moins un oxydant de la charge lors du déclenchement de celle-ci dégage des métaux bons conducteurs, notamment des métaux précieux ou semi-précieux qui se déposent sur des pièces électroniques de l'appareil électronique.

2. Dispositif selon la revendication 1,
**caractérisé en ce que**
le combustible et/ou l'oxydant dégagent les métaux sous forme de vapeur ou d'aérosols (liquides ou solides).

3. Dispositif selon la revendication 1 ou 2,
**caractérisé en ce qu'**
une charge (3) est disposée dans la zone de la platine et/ou d'un moyen de mémoire de l'appareil électrique.

4. Dispositif selon l'une quelconque des revendications 1 à 3,
**caractérisé en ce que**
l'oxydant du groupe des nitrates de métaux précieux ou semi-précieux, des nitrates d'amminemétal, présente des mélanges de ceux-ci.

5. Dispositif selon la revendication 4,
**caractérisé en ce que**
l'oxydant présente des composés de cuivre de métaux précieux ou semi-précieux du groupe du diaminodinitrate de cuivre [Cu(NH₃)₂] (NO₃)₂, du tétraaminodinitrate de cuivre [Cu(NH₃)₄ (NO₃)₂, du nitrate de cuivre basique Cu(NO₃)₂ . 3 Cu(OH)₂ ou des mélanges de ceux-ci.

6. Dispositif selon l'une quelconque des revendications 1 à 5,
**caractérisé en ce que**
le combustible est choisi dans le groupe des métaux précieux ou semi-précieux présentant une grande réactivité à l'oxygène, des alliages ou des mélanges de ceux-ci, ou des alliages ou mélanges de ceux-ci les déchargeant sous la forme de particules fines.

7. Dispositif selon la revendication 6,
**caractérisé en ce que**
le combustible est choisi dans le groupe aluminium (Al), silicium (Si), magnésium (Mg), titane (Ti), tungstène (W), zirconium (Zr), cuivre (Cu), bore (B) ou des mélanges de ceux-ci sous une forme à particules fines.

8. Dispositif selon l'une quelconque des revendications 1 à 7,
**caractérisé en ce que**
le combustible est choisi dans le groupe des composés organométalliques.

9. Dispositif selon l'une quelconque des revendications 1 à 8,
**caractérisé en ce que**
le combustible est choisi dans le groupe des composés métal-hydrogène.

10. Dispositif selon l'une quelconque des revendications précédentes,
**caractérisé en ce que**
le générateur de gaz (1) présente un allumeur en liaison active avec la charge (3).

11. Dispositif selon la revendication 10,
**caractérisé en ce que**
l'allumeur peut être déclenché manuellement.

12. Dispositif selon la revendication 10 ou 11,
**caractérisé en ce que**
l'allumeur peut être déclenché par capteurs.

13. Dispositif selon l'une quelconque des revendications 11 à 12,
**caractérisé en ce que**
l'allumeur peut être déclenché par commande à distance.

14. Mémoire avec un dispositif selon l'une quelconque des revendications 1 à 11.

15. Lecteur comprenant un moyen de mémoire et présentant un dispositif selon l'une quelconque des revendications 1 à 11.

16. Procédé pour rendre inutilisables des appareils électroniques,
**caractérisé en ce qu'**
un générateur de gaz prévu dans un appareil de ce type est allumé par une charge pyrotechnique qui contient au moins un combustible ou au moins un oxydant dont au moins un dégage, lors du déclenchement de la charge, des métaux bons conducteurs, notamment des métaux précieux ou semi-précieux qui se déposent sur des pièces électroniques de l'appareil électronique.

17. Procédé selon la revendication 16,
**caractérisé en ce que**
le combustible ou l'oxydant dégage des métaux sous forme de vapeur ou d'aérosols (liquides ou solides).

18. Procédé selon la revendication 16 ou 17,
**caractérisé par**
une charge disposée dans la zone de la platine et/ou d'un moyen de mémoire de l'appareil électronique.

19. Procédé selon l'une quelconque des revendications 16 à 18,
**caractérisé en ce qu'**
on utilise un oxydant du groupe des nitrates de métaux précieux ou semi-précieux, des nitrates d'amine de métal ou des mélanges de ceux-ci.

20. Procédé selon la revendication 19,
**caractérisé en ce qu'**
on utilise un oxydant en composés de cuivre de métaux précieux ou semi-précieux du groupe du diaminodinitrate de cuivre [Cu(NH₃)₂] (NO₃)₂, du tétraaminodinitrate de cuivre [Cu(NH₃)₄ (NO₃)₂, du nitrate de cuivre basique Cu(NO₃)₂ . 3 Cu(OH)₂ ou des mélanges de ceux-ci.

21. Procédé selon l'une quelconque des revendications 16 à 20,
**caractérisé en ce qu'**
on utilise un combustible du groupe des métaux précieux ou semi-précieux présentant une grande réactivité à l'oxygène, des alliages ou des mélanges de ceux-ci, ou des alliages ou mélanges de ceux-ci les déchargeant sous la forme de particules fines.

22. Procédé selon la revendication 21,
**caractérisé en ce qu'**
on utilise un combustible choisi dans le groupe aluminium (Al), silicium (Si), magnésium (Mg), titane (Ti), tungstène (W), zirconium (Zr), cuivre (Cu), bore (B) ou des mélanges de ceux-ci sous la forme de particules fines.

23. Procédé selon l'une quelconque des revendications 16 à 21,
**caractérisé en ce qu'**
on utilise un combustible du groupe des composés organométalliques.

24. Procédé l'une quelconque des revendications 16 à 24,
**caractérisé en ce qu'**
on utilise un combustible du groupe des composés métal-hydrogène.

25. Procédé selon l'une quelconque des revendications 16 à 24,
**caractérisé en ce que**
la charge est allumée au moyen d'un allumeur du générateur de gaz en liaison active avec celle-ci.
